# DEMANDE DE BREVET EUROPEEN

(11) **EP 4 528 735 A1**
(43) Date de publication de la demande: **26.03.2025**
(21) Numéro de dépôt: 24199047.2
(22) Date de dépôt: 06.09.2024
(51) Int. Cl.: G11C 7/20, G11C 7/24, G11C 11/417

(54) **DISPOSITIF AMELIORE DE GESTION D'INITIALISATION DE MEMOIRE SRAM**

(30) Priorité: 19.09.2023 FR 2309897
(71) Demandeur: Commissariat à l'Energie Atomique et aux Energies Alternatives, 75015 Paris (FR)
(72) Inventeur: NOEL, Jean-Philippe, 38000 Grenoble (FR); GIRAUD, Bastien, 38000 Grenoble (FR)
(74) Mandataire: Brevalex

(57) **Abrégé**

Unité de commande (100, 200) d'une mémoire SRAM pour déclencher une initialisation, sélectionnée parmi différents types d'initialisation distincts possibles, d'au moins un groupe donné de cellules mémoires SRAM de ladite mémoire SRAM, ladite unité de commande configurée pour adopter un mode de fonctionnement « verrouillé », dans lequel elle déclenche une initialisation du groupe donné de cellules selon un type d'initialisation « par défaut » correspondant à un premier type d'initialisation parmi lesdits différents types d'initialisation distincts ou un effacement, et maintient en sortie (OM1) ledit signal de commande (Z', R') « de masquage dur » dans un même état donné tant qu'une séquence de signaux particulière dite « de déverrouillage » n'est pas reçue sur lesdites entrées (HM1, HM2) de masquage dur, l'unité de commande étant configurée en outre pour, consécutivement à la réception de ladite séquence de signaux particulière dite « de déverrouillage » permettre l'initialisation du groupe donné selon différents types d'initialisation qui peuvent être distincts de l'initialisation par défaut.

## Description

### DOMAINE TECHNIQUE

La présente invention se rapporte au domaine des mémoires, et en particulier de type SRAM (SRAM pour « *Static Random Access Memory* » ou mémoire vive statique à accès aléatoire), et concerne plus précisément celui de l'initialisation des mémoires SRAM.

La présente invention met en oeuvre un dispositif amélioré permettant de gérer la sélection d'un type d'initialisation parmi plusieurs types d'initialisation possibles d'un groupe de cellules mémoires lors de la mise sous tension de ce groupe de cellules et de modes de fonctionnements particuliers tels qu'un mode de fonctionnement sécurisé ou d'évènements particuliers tels qu'une détection d'accès frauduleux à la mémoire.

### ÉTAT DE LA TECHNIQUE ANTÉRIEURE

Il existe un nombre réduit de techniques d'initialisation d'une mémoire SRAM.

Un type connu d'initialisation est l'initialisation dite « libre », qui consiste en un allumage sans contraintes d'un plan de cellules de mémoire. Avec une initialisation libre, l'état dans lequel chaque cellule est initialisée est établi librement. En particulier, lors d'un allumage sans contraintes d'une *k*-éme puce parmi un très grand nombre *Nₚ* ~ 10 000 de puces produites, la cellule de l'*i*-ème colonne et de la *j*-éme ligne a une probabilité *pᵢⱼₖ* de s'initialiser à un niveau logique '1' et une probabilité *1-pᵢⱼₖ* de s'initialiser à un niveau logique '0'. Sur un grand nombre ~ 100 d'initialisations sans contrainte, la moyenne des valeurs d'initialisation de la cellule de l'*i*-éme colonne et de la *j*-éme ligne dans un plan mémoire de la *k*-éme puce tendra vers cette valeur de probabilité *pᵢⱼₖ.* Il se trouve que cette valeur de probabilité change d'une cellule à l'autre et entre une puce et l'autre, d'une manière que sur un ensemble des cellules de puces différentes on aura une statistique de *p* qui dépend notamment de la variabilité locale de son procédé de fabrication et plus globalement de conditions PT (« Process », « Température », i.e. procédé de fabrication, température) autrement dit des variations locales et globales du procédé de fabrication, de la vitesse de balayage *V_{SR}* (« slew-rate » selon la terminologie anglo-saxonne exprimé en Volt/seconds) du niveau de tension d'alimentation utilisés, et de la température de fonctionnement.

Avec une telle technique d'initialisation, l'état d'initialisation de la mémoire ou de certaines cellules de la mémoire est ainsi susceptible de constituer une empreinte ou signature numérique. Pour un *k* fixé, ce sont en particulier les cellules avec une forte probabilité de commuter et de s'initialiser à un niveau logique donné (*pᵢⱼₖ* égal ou très proche de 1 pour les cellules à forte tendance de s'initialiser à '1' ; et *pᵢⱼₖ* égal ou très proche de 0 pour les cellules à forte tendance de s'initialiser à '0') qui pourront être utilisées pour former cette empreinte numérique de la *k*-ème puce.

Un inconvénient de l'initialisation libre peut être, qu'en cas d'intrusion malveillante après une telle initialisation, un dispositif tiers peut éventuellement récupérer cette empreinte ou signature numérique.

Une autre technique d'initialisation dite « déterministe » consiste à venir écrire, adresse après adresse, un contenu prédéterminé et qui peut avoir été préalablement fixé par l'utilisateur ou le concepteur de la mémoire. Parmi les techniques d'initialisation déterministe le type « mise à 0 » dans laquelle on force l'état de chaque cellule mémoire à une valeur logique '0' ou de type « mise à 1 » dans laquelle on force l'état de chaque cellule mémoire à une valeur logique '1' ou de type « mise à 1 ». La mise en oeuvre de ce type d'initialisation se fait ici au détriment du temps passé à réécrire un certain nombre de points mémoire à différentes adresses, au détriment de la consommation associée ainsi qu'au risque d'une fuite d'information liée à cette réécriture ou réalisée d'une façon malveillante pendant cette longue opération.

Il existe donc un besoin de pouvoir gérer différents types d'initialisation et de pouvoir initialiser un ensemble de cellules mémoires selon un type d'initialisation sélectionné parmi plusieurs types d'initialisation distincts.

Par ailleurs, les transistors de type PMOS utilisés dans les cellules SRAM subissent un phénomène physique appelé NBTI (en anglais « *Negative-Bias Temperature Instability »,* c'est à dire *« Instabilité de température en polarisation négative »*), qui a pour effet d'augmenter leur tension de seuil, ceci d'autant plus lorsque leurs dimensions (longueur et largeur de grille) sont réduites. Ce phénomène est par ailleurs accéléré quand la température et/ou la tension négative VGS appliquée entre la grille et la source du transistor augmentent. Une cellule mémoire SRAM est communément dotée de deux inverseurs connectés de façon croisée tête-bêche, chacun étant formé notamment d'un premier transistor de type P et d'un deuxième transistor de type N.

La valeur mémorisée dans une cellule mémoire SRAM va influencer différemment les transistors PMOS d'une même cellule mémoire et le ratio VTP1/VTP2 des tensions de seuil respectives des deux transistors PMOS va évoluer dans le temps dans un sens ou dans l'autre en fonction de la valeur mémorisée.

Ainsi, le phénomène NBTI influence la probabilité d'une cellule SRAM à s'initialiser spontanément lors de sa mise sous tension au niveau logique '1' ou à son niveau opposé '0', étant donné que le niveau logique d'initialisation est lié au ratio VTP1/VTP2.

Or, des données mémoires issues de l'initialisation de cellules SRAM peuvent être utilisées pour générer des clés de chiffrement ou un identifiant matériel ou une empreinte numérique unique. Elles peuvent être utilisées pour constituer ainsi une fonction physique non clonable (PUF pour « Physical Unclonable Function »).

Certaines cellules présentant un fort ratio VTP1/VTP2 peuvent être en particulier identifiées comme cellules suffisamment stables pour être utilisées pour constituer une fonction PUF lors d'une phase dite d'enrôlement (« enrollment » selon la terminologie anglo-saxonne). Néanmoins, à cause des effets du phénomène NBTI précité, le ratio VTP1/VTP2 peut avec le temps être amené à être modifié, ce qui rend les cellules moins propices à leur utilisation pour constituer un PUF, dont un des prérequis est la stabilité temporelle sur long terme.

Une problématique liée aux effets du NBTI et qui influe sur la sécurisation des données est l'effet dit « d'impression des données » (« *data imprint effect* »). Un tel effet est décrit dans le document : *"*Challenging On-Chip SRAM Security with Boot-State Statistics", de J. McMahan et al., HOST 2017. Lorsqu'une donnée stockée en mémoire y reste longtemps (avec une mémoire en fonctionnement, sous alimentation électrique), la tension de seuil VTP du transistor PMOS passant évolue, dû au même effet physique qui cause le NBTI. Un effet de rémanence néfaste ou « d'impression des données » (« data imprint » en anglais) fait alors qu'il peut être possible de retrouver une donnée qui a été stockée préalablement même lorsque la mémoire est réinitialisée.

Des techniques telles que l'« analyse de consommation » (connues sous le nom de « CPA » ou « DPA » selon les acronymes anglais « correlated Power analysis » ou « differential power analysis ») peuvent être employées pour révéler des données destinées à rester secrètes, en se basant entre autres sur ce phénomène de dérive de la tension de seuil des transistors en utilisant des moyens pour accélérer cette dérive. Une telle technique est décrite par exemple dans le document : *"*Power Analysis Résilient SRAM Design Implemented with a 1% Area Overhead Impédance Randomization Unit for Security Applications", de R. Giterman et al., ESSCIRC 2019.

Il existe également un besoin de trouver un dispositif de commande prévu pour gérer différents types d'initialisation d'une mémoire et qui permette de pouvoir améliorer le fonctionnement de la mémoire vis-à-vis des effets du NBTI.

### EXPOSÉ DE L'INVENTION

Selon un aspect, la présente demande concerne une unité de commande pour une mémoire SRAM apte à déclencher une initialisation, sélectionnée parmi différents types d'initialisation distincts possibles, d'au moins un groupe donné de cellules mémoires SRAM de ladite mémoire SRAM, ladite unité de commande comprenant :
- une première entrée dite « de masquage dur », apte à recevoir un signal dit « de détection »,
- une deuxième entrée dite « de masquage dur », apte à recevoir un signal dit « d'activation »,
- une ou plusieurs entrées dites « de masquage doux » aptes à recevoir des signaux indicateurs d'initialisation selon différents types d'initialisation distincts,

ladite unité de commande étant configurée pour adopter un mode de fonctionnement dit « verrouillé », dans lequel consécutivement à une mise sous tension de la mémoire et quelle que soit la valeur de signaux émis sur la première entrée et la deuxième entrée de masquage dur et sur les entrées de masquage doux, ou consécutivement à la réception d'une séquence dite « de verrouillage sur ladite première entrée de masquage dur,
ladite unité de commande produise en sortie un signal de commande apte à déclencher une initialisation dudit groupe donné de cellules selon un type d'initialisation dit « par défaut » correspondant à un premier type d'initialisation parmi lesdits différents types d'initialisation distincts ou un effacement, et maintient en sortie ledit signal de commande dans un même état donné tant qu'une séquence de signaux particulière dite « de déverrouillage » n'est pas reçue sur lesdites entrées de masquage dur,
ladite unité de commande étant configurée en outre pour, consécutivement à la réception de ladite séquence de signaux particulière dite « de déverrouillage » sur lesdites entrées de masquage dur, adopter au moins un autre mode de fonctionnement dans lequel, en l'absence de nouveaux signaux ou de changement d'état de signaux sur lesdites entrées de masquage dur, lorsque ladite unité de commande reçoit un signal indicateur d'initialisation du premier type d'initialisation, produire en sortie un signal de commande d'initialisation du premier type pour déclencher une initialisation des cellules mémoires dudit groupe donné de cellules selon ledit premier type d'initialisation et lorsque l'unité de commande reçoit un signal indicateur d'initialisation du deuxième type d'initialisation, produire en sortie un signal de commande d'initialisation d'un deuxième type pour déclencher une initialisation des cellules mémoires dudit groupe donné de cellules selon ledit deuxième type d'initialisation.

Avantageusement, le signal de détection peut provenir d'un module de détection d'accès frauduleux à ladite mémoire SRAM, ladite séquence de verrouillage sur ladite première entrée de masquage dur correspondant à un changement d'état dudit signal de détection.

Selon une possibilité de mise en oeuvre, la séquence de déverrouillage peut consister, dans cet ordre, en un état logique donné ou un changement d'état logique dudit signal de détection sur ladite première entrée de masquage dur vers ledit état logique donné puis, un changement du signal d'activation sur ladite deuxième entrée de masquage dur.

Dans ledit au moins un autre mode de fonctionnement, l'unité de commande peut être configurée en outre pour, consécutivement à la réception dudit signal d'activation sur la deuxième entrée « de masquage dur » et en l'absence de changement d'état du signal de détection sur la première entrée « de masquage dur », émettre un signal de commande d'initialisation du premier type pour déclencher une initialisation des cellules mémoires dudit groupe donné selon ledit premier type d'initialisation.

Selon une possibilité de mise en oeuvre, l'unité de commande peut être dotée : d'un module logique à bascule asynchrone ayant une entrée dite « de contrôle » couplée à la première entrée de masquage dur et une autre entrée dite « de contrôle » couplée à la deuxième entrée de masquage dur, ledit module logique étant configuré pour, consécutivement à une mise sous tension ou à la réception de ladite séquence de verrouillage, maintenir en sortie un premier état logique tant que ledit module logique ne reçoit pas ladite séquence de déverrouillage et pour, consécutivement à la réception de ladite séquence de déverrouillage produire en sortie un deuxième état logique complémentaire dudit premier état logique.

L'unité de commande peut comprendre en outre un étage à portes logiques couplé à une sortie dudit module logique et auxdites entrées de masquage doux, ledit étage à portes logiques étant doté :
- d'au moins une première porte logique réalisant une fonction logique donnée, en particulier réalisant une fonction OU entre une première entrée de masquage doux et le complémentaire d'une sortie dudit module logique, une sortie de la première porte logique étant couplée à une première sortie de l'unité de commande prévue pour délivrer le signal de commande d'initialisation du premier type,
- d'au moins une deuxième porte logique réalisant une fonction logique distincte de la fonction logique donnée, en particulier une fonction ET entre une deuxième entrée de ladite pluralité d'entrées « de masquage doux » et la sortie dudit module logique étant couplée à une deuxième sortie de l'unité de commande prévue pour délivrer le signal de commande d'initialisation du deuxième type.

Selon une possibilité de mise en oeuvre de l'unité de commande, le module logique à bascule asynchrone peut être doté d'une bascule asynchrone asymétrique tel qu'une bascule RS asymétrique.

Avantageusement, ladite bascule asynchrone peut être formée d'un premier ensemble de transistors réalisant une fonction logique donnée, en particulier une fonction NON OU ou une fonction NON ET, et d'un deuxième ensemble de transistors réalisant ladite même fonction logique donnée, ladite bascule asynchrone étant asymétrique de sorte que ledit premier ensemble de transistors est doté d'au moins un premier groupe de transistors ayant un agencement semblable à celui d'un deuxième groupe de transistors dudit deuxième ensemble de transistors, les transistors du premier groupe étant prévus avec une tension de seuil différente de celle des transistors dudit deuxième groupe.

Selon une possibilité de réalisation de l'unité de commande, parmi lesdites entrées de masquage doux peut figurer :
- une première entrée de masquage doux est apte à recevoir un signal indicateur d'initialisation d'un premier type d'initialisation,
- une deuxième entrée de masquage doux, apte à recevoir un signal indicateur d'initialisation d'un deuxième type d'initialisation parmi lesdites différents types d'initialisation, le deuxième type d'initialisation étant distinct dudit premier type d'initialisation et dudit deuxième type d'initialisation,
- une troisième entrée de masquage doux, apte à recevoir un signal indicateur d'initialisation d'un troisième type d'initialisation parmi lesdites différents types d'initialisation, le troisième type d'initialisation étant distinct dudit premier type d'initialisation et dudit deuxième type d'initialisation,
dans laquelle dans ledit au moins un autre mode de fonctionnement lorsque la troisième entrée de masquage doux reçoit un signal indicateur d'initialisation du troisième type d'initialisation, l'unité de commande produit en sortie un signal de commande d'initialisation d'un troisième type pour déclencher une initialisation des cellules mémoires dudit groupe donné de cellules selon ledit troisième type d'initialisation.

Selon une possibilité de mise en oeuvre, le premier type d'initialisation et le deuxième type d'initialisation sont des types d'initialisation distincts parmi :
- une initialisation de type «mise à 1 » ou « mise à 0 » consistant à mettre toutes les cellules dudit groupe à un même état logique,
- une initialisation de type « aléatoire » consistant à imposer à chaque colonne de cellules dudit groupe un même état logique donné sélectionné de manière aléatoire entre un premier état logique et un deuxième état logique,
- une initialisation de type « libre » consistant à mettre les noeuds internes de chaque cellule dudit groupe à un même potentiel puis laisser ces noeuds internes respectivement se charger ou se décharger afin de laisser la cellule s'établir librement à un état logique donné.

Dans le mode de fonctionnement verrouillé, le maintien en sortie dudit signal de commande dans un même état donné est apte à maintenir ledit groupe donné de cellules dans un état indéterminé dit « métastable » pour lequel leur premier noeud de stockage et leur deuxième noeud de stockage respectifs sont mis à des potentiels égaux ou sensiblement égaux.

Selon un autre aspect, la présente demande concerne un dispositif de mémoire statique à accès aléatoire comprenant :
- un ensemble de cellules SRAM comprenant ledit groupe donné de cellules SRAM,
- au moins une première unité de commande telle que définie précédemment, pour initialiser ledit groupe donné dudit ensemble de cellules SRAM.

Avantageusement, le dispositif de mémoire statique à accès aléatoire peut comprendre en outre: une deuxième unité de commande, pour commander l'initialisation, selon différents types d'initialisation distincts possibles, des cellules mémoires d'un deuxième groupe de cellules dudit ensemble de cellules mémoires SRAM distinct dudit groupe donné.

Avantageusement, le groupe donné de cellules peut contenir une fonction physique non clonable (PUF), tandis que le deuxième groupe de cellules correspondant à des cellules de stockage de données sensible ou à des cellules en accès libre.

Selon une possibilité de mise en oeuvre du dispositif de mémoire statique à accès aléatoire, la deuxième unité de commande peut être configurée pour, consécutivement à chaque mise sous tension de la mémoire ou consécutivement à la réception d'un signal de verrouillage, produire en sortie un signal de commande d'initialisation pour déclencher une initialisation dudit deuxième groupe de cellules selon un type d'initialisation par défaut parmi lesdits différents types d'initialisation distincts, le type d'initialisation par défaut de la deuxième unité de commande étant différent du type d'initialisation par défaut de la première unité de commande et sélectionné parmi :
- une initialisation de type «mise à 1 » ou « mise à 0 » consistant à mettre toutes les cellules dudit groupe à un même état logique,
- une initialisation de type « déterministe aléatoire » consistant à imposer à chaque colonne de cellules dudit groupe un même état logique donné sélectionné de par tirage aléatoire entre un premier état logique et un deuxième état logique,
- une initialisation de type « libre » consistant à mettre les noeuds internes de chaque cellule dudit groupe à un même potentiel puis laisser ces noeuds internes respectivement se charger ou se décharger afin de laisser la cellule s'établir librement à un état logique donné.

Avantageusement, le type d'initialisation par défaut de la première unité de commande peut être une initialisation de type «mise à 1 » ou « mise à 0 » consistant à mettre toutes les cellules dudit groupe à un même état logique, le type d'initialisation par défaut de la deuxième unité de commande étant une initialisation de type « déterministe aléatoire » consistant à imposer à chaque colonne de cellules dudit groupe un même état logique donné sélectionné de manière aléatoire entre un premier état logique et un deuxième état logique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
La figure 1 donne un exemple de réalisation d'une unité de commande dans une mémoire SRAM capable de déclencher une initialisation d'au moins un premier groupe de cellules d'une mémoire SRAM, selon un type d'initialisation sélectionné parmi plusieurs types d'initialisation possibles.
La figure 2 donne un exemple de table de vérité pour illustrer le fonctionnement de l'unité de commande selon la figure 1.
La figure 3 sert à illustrer différents modes de fonctionnement d'un exemple de module logique dit « à verrouillage » intégré dans une unité de commande telle que mise en oeuvre suivant l'invention.
La figure 4 sert à illustrer un exemple de structure du module logique dit « à verrouillage » et doté en particulier d'une bascule asynchrone et asymétrique.
La figure 5 donne un exemple de bascule asynchrone et asymétrique susceptible d'être prévue dans un module logique « à verrouillage ».
La figure 6 sert à illustrer une deuxième unité de commande prévue pour déclencher une initialisation d'un deuxième groupe de cellules d'une mémoire SRAM distinct du groupe de cellules auquel l'unité de commande de la figure 1 est associé.
La figure 7 sert à illustrer différentes zones d'un plan mémoire SRAM et associées chacune à une unité de commande.
La figure 8 donne un exemple de structure conventionnelle de cellule mémoire SRAM.
La figure 9 donne par le biais d'un chronogramme un exemple gestion des initialisations pour différentes zones d'une matrice de cellule et selon différents modes de fonctionnement, normal ou sécurisé.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

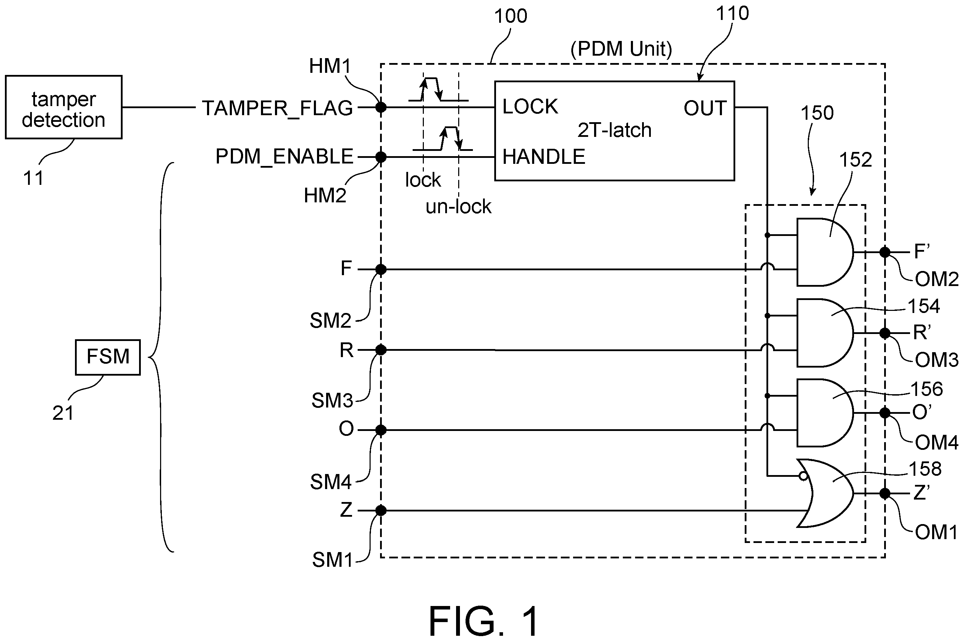

Un exemple de réalisation d'une unité 100 de commande configurée pour déclencher une initialisation d'au moins un groupe donné de cellules SRAM d'une mémoire SRAM est représenté de manière schématique sur la figure 1.

Cette unité 100 de commande est apte déclencher différents types d'initialisation distincts et permet de déclencher une initialisation dudit au moins un groupe donné de cellules selon un type d'initialisation sélectionné parmi différents types d'initialisation distincts.

Cette unité 100 de commande d'initialisation permet, après mise sous tension de la mémoire ou dans un mode de fonctionnement particulier lié par exemple à une détection de tentative d'intrusion, de mettre en oeuvre une initialisation selon un type d'initialisation dit « par défaut » parmi les différents types d'initialisation ou un effacement du groupe donné de cellules.

Cette unité 100 de commande d'initialisation permet également de déclencher des séquences de plusieurs initialisation successives chacune selon un type d'initialisation qui peut être différent de la précédente afin notamment d'éviter les phénomènes d'impression des données (« data imprint »).

L'unité 100 de commande d'initialisation comporte ici une première entrée HM1 dite « de masquage dur » pour la réception d'un premier signal logique TAMPER_FLAG dit « de détection ». Ce signal de détection TAMPER_FLAG peut être par exemple un signal indicateur d'une tentative d'accès frauduleux à la mémoire et peut en particulier provenir d'un module 11 de détection d'intrusion. Un tel module 11 de détection d'accès frauduleux peut être doté de fonctions semblables à celles d'un module TAMP présent dans un microcontrôleur STM32GO commercialisé par la société STMicroelectronics et décrit dans la notice « STM32GO - TAMP, tamper and back-up registers, revision 1.0 ».

Le signal de détection TAMPER_FLAG est transmis de manière asynchrone et peut être tel que par exemple qu'un état haut (ou un '1' logique) indique une tentative d'accès frauduleux à la mémoire.

En variante, le premier signal logique TAMPER_FLAG dit « de détection » peut être émis par un autre élément externe au circuit mémoire_{[AP1]}, et émis en prévention, avant même une tentative d'accès frauduleux.

L'unité 100 de commande d'initialisation comporte également une deuxième entrée HM2 dite « de masquage dur », pour la réception d'un deuxième signal logique dit « d'activation ». Ce signal d'activation PDM_ENABLE peut provenir d'un bloc 21 de circuit de la mémoire formant une machine d'états (FSM pour « Finite State Machine ») et réalisée typiquement à partir d'un dispositif logique programmable. Un tel dispositif peut être muni d'au moins un registre pour stocker des variables d'état ainsi que de blocs de logique combinatoire. Les changements du signal d'activation PDM_ENABLE peuvent dépendre de différents modes de fonctionnement, par exemple un mode normal et un mode sécurisé également appelé « crypto » dans lesquels on souhaite mettre un groupe de cellules mémoires.

L'unité 100 de commande comporte une première entrée SM1 dite « de masquage doux », prévue pour la réception d'un signal logique Z indicateur d'un premier type d'initialisation, dans cet exemple de type « de mise à 0 » des cellules mémoires.

Une deuxième entrée SM2 de masquage doux est prévue pour la réception d'un signal logique F indicateur d'un deuxième type d'initialisation, ici correspondant à une initialisation dite « libre » de cellules mémoires.

Une troisième entrée SM3 de masquage doux peut être également prévue pour la réception d'un signal logique R indicateur d'un troisième type d'initialisation, ici correspondant à une initialisation dite « aléatoire » (et qui peut être également appelée « déterministe aléatoire » ou « aléatoire par colonne ») de cellules mémoires.

Dans cet exemple de réalisation, une quatrième entrée SM4 de masquage doux est également prévue pour la réception d'un signal logique O indicateur d'un quatrième type d'initialisation dans cet exemple de type « de mise à 1 » des cellules mémoires.

Les signaux indicateurs O, F, R, Z émis respectivement sur les entrées SM1, SM2, SM3, SM4 peuvent être tous issus de la machine d'états 21 produisant le signal d'activation PDM_ENABLE.

L'unité de commande 100 est ici formée d'un module 110 logique à bascule asynchrone ayant une entrée LOCK couplée à la première entrée HM1 de masquage dur et une autre entrée HANDLE couplée à la deuxième entrée HM2 de masquage dur. Ce module logique 110 produit en sortie un signal de sortie OUT logique dont l'état est transmis à un étage 150 logique. Les entrées du module 110 sont, dans cet exemple, directement reliées respectivement aux entrées de masquage dur HM1, HM2.

L'étage 150 est lui-même couplé aux entrées SM1, SM2, SM3, SM4 de masquage doux et produit en fonction de la valeur du signal de sortie OUT du module 110 et des valeurs des signaux F, R, O, Z indicateurs chacun d'un type d'initialisation, un ou plusieurs signaux de commande d'initialisation F', R', O', Z' permettant de déclencher différents types d'initialisation à destination d'au moins un circuit d'initialisation.

Ce circuit d'initialisation (non représenté sur cette figure) est lui-même configuré pour initialiser ledit au moins un groupe donné de cellules mémoires, selon différents types d'initialisation distincts en fonction des signaux de commande d'initialisation F', R', O', Z' reçus.

Dans l'exemple de réalisation particulier illustré, l'étage 150 logique est formé d'un ensemble de portes logiques 152, 154, 156, 158.

Une porte logique 158 dudit ensemble de portes logiques réalise ici une fonction OU entre la première entrée SM1 de masquage doux et le complémentaire de la sortie OUT du module 110 pour produire en une première sortie OM1 de l'unité de commande 100 un signal de commande Z' dit « de masquage dur » ou premier signal de commande d'initialisation permettant de déclencher une initialisation de cellules selon le type d'initialisation dit « de mise à 0 ».

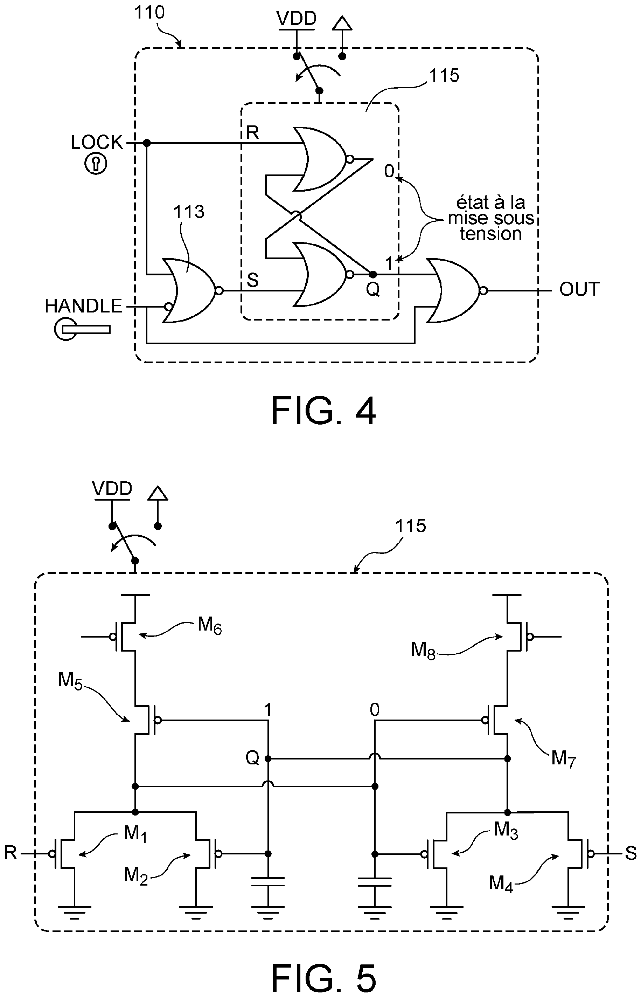

Un circuit d'initialisation du type de celui décrit dans la demande n°2111286, notamment en lien avec sa figure 4, peut être déclenché par le signal Z' afin de permettre d'écrire toutes les cellules mémoire à « 0 » et mettre en oeuvre ainsi une initialisation de type « mise à 0 ».

Un deuxième signal de commande d'initialisation F', d'un autre type initialisation que le signal de commande Z', est susceptible d'être produit sur une deuxième sortie OM2 de l'unité de commande 100 et en particulier par le biais d'une porte logique 152 de l'étage 150. Cette porte 152 réalise dans cet exemple une fonction logique différente de celle de la porte 158, ici une fonction ET, entre la deuxième entrée SM2 de masquage doux et la sortie OUT du module 110. Le signal de commande d'initialisation F' est ici prévu pour déclencher une initialisation dudit groupe de cellules selon une initialisation de type « libre ».

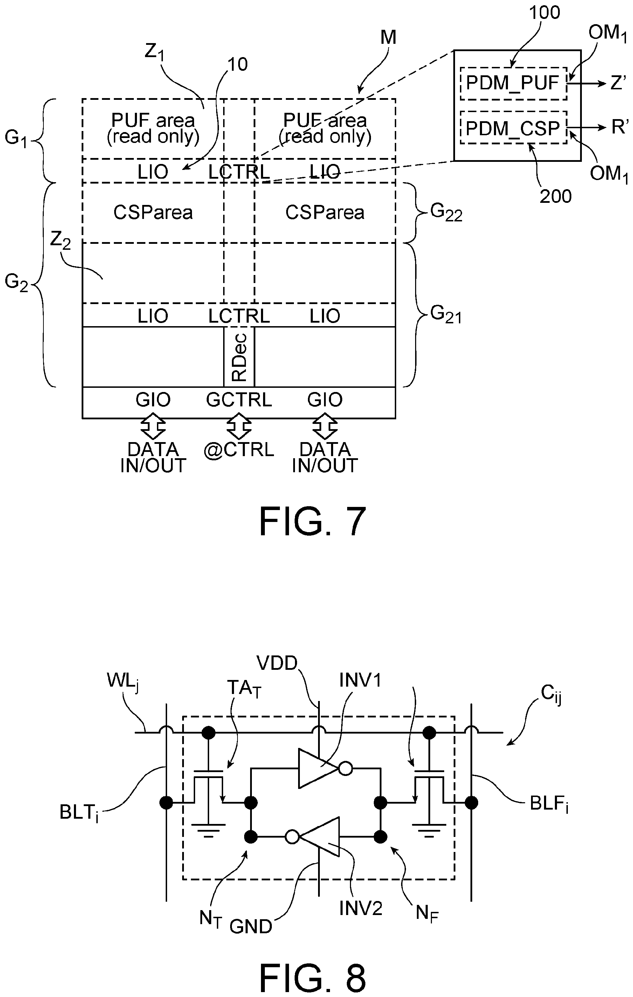

On peut se référer à une demande de brevet français n°2111286 déposée par la demanderesse le 25 Octobre 2021 devant l'Institut National qui décrit un circuit d'initialisation de la mémoire SRAM, configuré pour mettre en oeuvre une initialisation de type libre. Ce type d'initialisation « libre », consiste à laisser chaque cellule mémoire s'initialiser à une valeur propre lors de la mise sous tension progressive des éléments constituants la cellule mémoire, notamment de deux inverseurs rebouclés tels qu'illustrés sur la figure 8, sans chercher à imposer de valeur « 0 » ou « 1 » sur les noeuds internes N_{T} et N_{F} de la cellule. Dans le mode d'initialisation libre, les transistors d'accès TA_{T} et TA_{F} sont non passants, la cellule étant comme « isolée » des autres cellules et des lignes de bits BLT et BLF.

Un troisième signal de commande d'initialisation R', dans cet exemple de type « aléatoire » des cellules est susceptible d'être produit sur une troisième sortie OM3 de l'unité de commande 100 par une porte logique 154 de l'étage 150 réalisant ici une fonction ET, entre l'entrée SM3 de masquage doux et la sortie OUT du module 110. Le troisième signal de commande d'initialisation est ici prévu pour déclencher une initialisation dudit groupe de cellules selon une initialisation de type « aléatoire ».

Dans une autre demande de brevet français n°2213917 déposée par la demanderesse le 20 décembre 2022 devant l'Institut National de la propriété industrielle un circuit d'initialisation pour mettre en oeuvre une initialisation de type aléatoire est décrit. Il permet d'imposer une valeur à tout ou partie des cellules d'une même colonne ; cette même valeur ayant été préalablement définie par un procédé de tirage aléatoire. On utilise l'expression initialisation « aléatoire » pour ce type d'initialisation procédant en deux temps, tirage aléatoire puis initialisation forcée. Pour ce type d'initialisation on peut ainsi avoir par exemple toutes les cellules d'une colonne mises dans un état correspondant à un « 0 » logique et toutes les cellules d'une deuxième colonne mises dans un état correspondant à un « 1 » logique, les états respectifs de ces colonnes étant le résultat de tirages aléatoires.

Un quatrième signal de commande d'initialisation O', dans cet exemple de type « mise à '1' » des cellules est susceptible d'être produit sur une quatrième sortie OM4 de l'unité de commande 100 par une porte logique 156 de l'étage 150 réalisant ici une fonction ET, entre l'entrée SM4 de masquage doux et la sortie OUT du module 110. Le quatrième signal de commande d'initialisation est ici prévu pour déclencher une initialisation dudit groupe de cellules selon une initialisation de type « mise à '1' ».

Un circuit d'initialisation décrit dans la demande n°2111286, notamment en lien avec sa figure 4, permet d'écrire toutes les cellules mémoire à « 1 » et mettre en oeuvre ainsi une initialisation de type « mise à 1 ». Pour ce faire, le dispositif mémoire prévoit de piloter, pour chaque colonne, une des lignes de bits BLT ou BLF en la connectant à une tension d'alimentation par mise en conduction d'un transistor de sélection de ligne de bits. La ligne de bits sélectionnée et alimentée tend ainsi à imposer une valeur « 1 » ou « 0 » sur un des noeuds de chaque cellule mémoire reliée à cette ligne de bits.

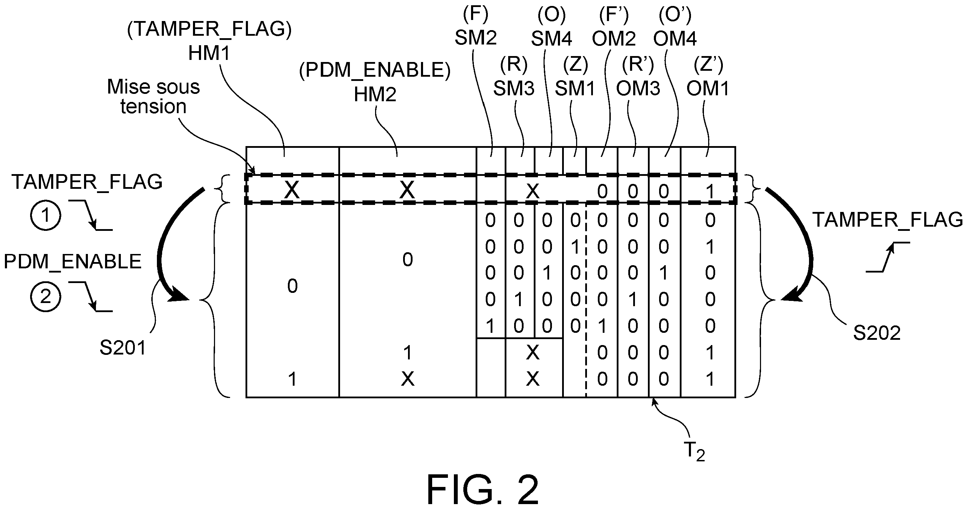

Un exemple de table de vérité T₂ illustrant le fonctionnement de l'unité de commande 100 de la figure 1 est donné sur la figure 2.

L'unité 100 de commande d'initialisation est configurée pour adopter un mode de fonctionnement dit « verrouillé » (première ligne de la table de vérité) dans lequel l'unité 10 de commande d'initialisation est configurée pour que consécutivement à une mise sous tension, quelle que soit la valeur de signaux émis sur la première entrée de masque dur HM1, sur la deuxième entrée HM2 de masquage dur et sur les entrées SM1, SM2, SM3, SM4 de masquage doux, l'unité de commande produise en sortie un signal de commande permettant de déclencher une initialisation dudit groupe donné de cellules selon un type d'initialisation dit « par défaut » ou un effacement dudit groupe donné de cellules préalablement à une mise dans un état métastable de ce groupe donné de cellules.

Dans le mode de fonctionnement dit « par défaut », le module logique 110 est mis dans un état dit « verrouillé » et produit en sortie OUT un même état logique donné, par exemple OUT='0', tant qu'il ne reçoit pas une séquence dite de déverrouillage pour le faire sortie de cet état donné.

L'état donné du signal Z' émis sur la première sortie OM1 est susceptible de provoquer un effacement des données et la mise dudit au moins un groupe de cellules dans un état dit « métastable » pour lequel leurs premier noeud et deuxième noeud sont mis à des potentiels égaux ou sensiblement égaux, notamment lorsque le groupe donné de cellules associé à l'unité de commande 100 sont destinées à réaliser une fonction physique non-clonable (PUF). La demande de brevet français n°2214117 déposée par la demanderesse le 21 décembre 2022 devant l'Institut National de la Propriété Intellectuelle prévoit un circuit configuré pour déclencher un tel effacement et une mise dans un état métastable. La première sortie OM1 peut être ainsi couplé à un tel type de circuit. Lors d'une opération d'effacement de la mémoire, les noeuds internes des cellules mémoires peuvent être positionnés à des valeurs identiques ou sensiblement identiques (i.e. qui diffèrent de moins 10 mV), soit par court-circuit, soit par décharge des noeuds suite à une coupure d'alimentation. Une phase possible d'initialisation consiste donc à faire passer une cellule mémoire d'un état « indéterminé » (et indéterminable par lecture) à un état avec une valeur mémorisée « déterminée » (et donc déterminable par lecture). La présente demande fait suite à d'autres demandes de brevets de la demanderesse en lien avec le sujet des dispositifs mémoires SRAM. On peut également se référer à la demande de brevet FR, n°1761692, déposée le 6 décembre 2017 dans laquelle un mécanisme d'effacement est décrit. On peut également se référer à la demande de brevet français n°2111286 déposée par la demanderesse le 25 Octobre 2021 devant l'Institut National de la Propriété Intellectuelle dans laquelle un effacement est également décrit.

Alternativement, lorsque le groupe donné de cellules associé à l'unité de commande 100 sont destinées stocker des données sensibles CSP (pour « Critical Security Parameters » ou paramètre de sécurité critique), le signal Z' émis sur la première sortie OM1 est susceptible de provoquer une initialisation de ce groupe donné selon le type d'initialisation dit « par défaut ». Dans l'exemple de réalisation particulier illustré le type d'initialisation par défaut correspond au premier type d'initialisation, autrement dit à une initialisation de type « mise à 0 » des cellules. Le signal Z' de commande peut ainsi permettre de déclencher une initialisation des cellules par « mise à 0 ». Ce signal Z' sur la sortie OM1 (ici correspondant à un état logique 1) permet ici, consécutivement à une mise sous tension de la mémoire, de déclencher une mise à 0 des cellules d'un groupe de cellules associé à l'unité de commande 100. Par « mise à 0 » des cellules, on entend ici une mise à un potentiel de leur premier noeud ou bien de leur deuxième noeud correspondant à un '0' logique en fonction duquel de ces noeuds complémentaires est sensé par convention établir l'état logique de la cellule.

Une séquence particulière des signaux de masquage dur sur les entrées HM1 et HM2 permet de sortir du mode de fonctionnement « par défaut ». La séquence de déverrouillage peut correspondre avantageusement à une succession de signaux sur la première entrée HM1 de masquage dur puis sur la deuxième entrée de masquage dur HM2.

Dans l'exemple de réalisation particulier illustré sur la figure 2, une séquence de déverrouillage S201 consiste, à appliquer un état logique donné, par exemple un '0' logique sur la première entrée de masquage dur, puis d'appliquer un front descendant (i.e. un passage d'un '1' logique à un '0' logique) sur la deuxième entrée de masquage dur.

Après réception d'une telle séquence, le module logique 110 n'est plus dans son état verrouillé et sa sortie n'est plus nécessairement dans l'état logique '0' et est ainsi susceptible d'être modifiée.

Un mode de fonctionnement de « masquage doux » peut être alors établi tant que de nouveaux signaux ou de changement d'état de signaux sur les entrées de masquage dur HM1, HM2 n'est pas détectée, ce qui se traduit dans cet exemple par un maintien d'état, en particulier un état bas ou un niveau logique '0', sur les entrées HM1, HM2, ce sont les signaux de masquage doux qui commandent l'initialisation.

Ainsi, dans ce mode de masquage doux, lorsque l'unité de commande 100 reçoit un signal indicateur Z d'initialisation « de type mise à 0 » sur son entrée SM1 (troisième ligne de la table de vérité), l'unité de commande 100 produit en sortie un signal de commande d'initialisation Z' de type « mise à 0 » pour déclencher une initialisation des cellules mémoires en effectuant une mise à un état logique '0' de ces cellules.

Dans le mode de masquage doux, lorsque l'unité de commande reçoit un signal indicateur F d'initialisation de type libre sur son entrée SM2 (sixième ligne de la table de vérité), l'unité de commande 100 produit en sortie un signal de commande d'initialisation F' de type libre pour déclencher une initialisation de type « libre » des cellules mémoires.

Lorsque l'unité de commande 100 reçoit un signal indicateur R' d'initialisation aléatoire sur son entrée SM3 (cinquième ligne de la table de vérité), elle produit en sortie un signal de commande d'initialisation R' de type « aléatoire » pour déclencher une initialisation aléatoire des cellules mémoires.

Lorsque l'unité de gestion d'initialisation reçoit un signal indicateur O d'initialisation de type « mise à 1 » sur son entrée SM4 (quatrième ligne de la table de vérité), l'unité de commande 100 produit en sortie un signal de commande d'initialisation O' de type « mise à 1 » pour déclencher une initialisation aléatoire des cellules mémoires en réalisant une mise à un état logique '1' ces cellules

Ainsi lorsqu'une entrée donnée de masquage doux SM1, SM2, SM3, SM4, reçoit un signal indicateur d'initialisation d'un type donné d'initialisation l'unité de commande produit en sortie un signal de commande d'initialisation pour déclencher une initialisation des cellules mémoires du secteur donné selon ledit type d'initialisation donné.

Lorsque le module 110 est déverrouillé, la réception d'un signal d'activation sur la deuxième entrée de masque dur HM2 qui se traduit dans cet exemple par une mise à 1 du signal PDM_ENABLE, entraine, tant qu'un signal de détection d'intrusion n'est pas détecté (traduite dans cet exemple par TAMPER_FLAG='0') à un mode de fonctionnement dans lequel quels que soient les signaux émis sur les entrées de masquage doux SM1, SM2, SM3, SM4, un signal de commande est émis sur la sortie OM4 pour déclencher une initialisation par défaut, ici de type mise à '0' sur le groupe de cellules associé à l'unité de commande 100.

L'unité 100 de commande d'initialisation est configurée pour adopter à nouveau le mode de fonctionnement dit « par défaut » consécutivement à la réception d'un signal ou indicateur de verrouillage sur ladite première entrée de masquage dur HM1.

Ainsi, un tel signal ou indicateur entraine un verrouillage S202 de la sortie OUT du module 110.

Ce verrouillage est mis en oeuvre par détection d'une nouvelle séquence S202, par exemple lorsqu'un front montant (passage d'un '0' logique à un '1' logique) sur le signal TAMPER_FLAG de détection d'intrusion est détecté. Suite à une telle détection, l'unité de commande 100 fonctionne à nouveau dans son mode par défaut dans lequel quelle que soit la valeur des entrées de masquage dur et de masquage doux, un signal logique de commande d'initialisation « par défaut » est produit, dans cet exemple sous forme d'un signal de commande d'initialisation de type « mise à 0 » produit en sortie OM4 de l'unité 100 de commande.

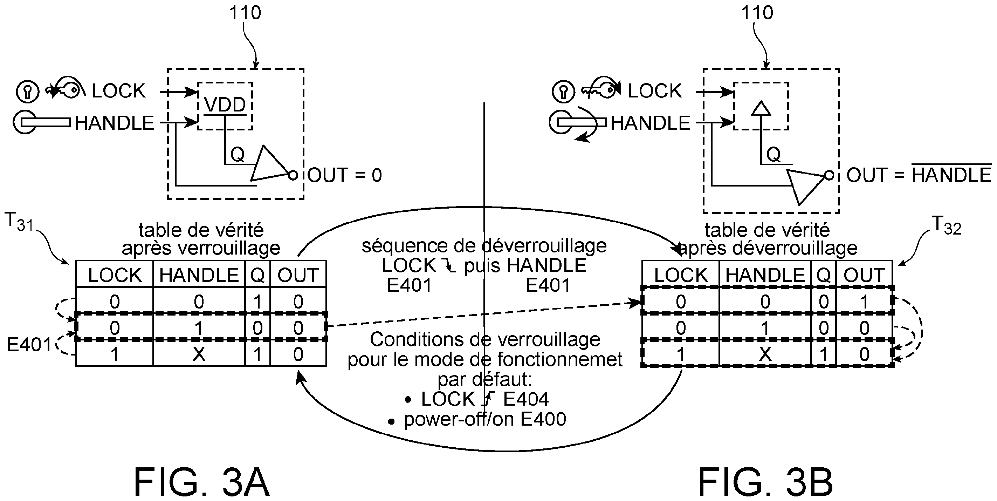

Sur la figure 3, différents modes de fonctionnement du module logique 110 sont illustrés par le biais d'une première table de vérité T₃₁ et d'une seconde table de vérité T₃₂.

Consécutivement à une mise sous tension (étape E400 correspondant ici à une mise à VDD d'un rail d'alimentation du module 110), la sortie OUT du module s'initialise toujours à un même état logique, ici par exemple un état logique OUT='0', et ce, quelle que soit la valeur de ses entrées de contrôle LOCK et HANDLE, elles-mêmes correspondant aux entrées de masquage dur.

Le module 100 se trouve alors (table de vérité T₃₁) dans le mode de fonctionnement « verrouillé » de l'unité de commande 100 et dans lequel sa sortie OUT reste toujours dans le même état logique, ici à '0'.

La séquence particulière de déverrouillage (étapes E401 puis E402) pour sortir le module 110 de son état « verrouillé » consiste par exemple à appliquer un 0 sur l'entrée LOCK avant d'appliquer un front descendant sur l'entrée HANDLE. Ainsi, consécutivement à la réception de la séquence de déverrouillage, le signal en sortie OUT du module 110 passe de l'état « verrouillé » au démarrage de l'alimentation, dans cet exemple '0', à un autre état, dans cet exemple à '1'. Cela permet de quitter le mode de fonctionnement par défaut de l'unité de commande décrite précédemment.

Ensuite, dans un mode de fonctionnement « déverrouillé » (table de vérité T₃₂) la sortie OUT est susceptible de changer d'état.

Dans le mode de fonctionnement « déverrouillé » du module 110, la sortie OUT peut repasser à un état logique '0' permettant de déclencher une initialisation de type « par défaut » (i.e. dans le mode de réalisation décrit précédemment correspondant à une initialisation de type « mise à 0 ») sans pour autant remettre le module 110 dans un état verrouillé. Cela est réalisé en passant à '1' le signal sur l'entrée HANDLE.

Pour mettre à nouveau dans un état « verrouillé » (étape E404) le module 110, le signal sur l'entrée LOCK est mis à 1.

Avant une extinction de l'alimentation, on peut prévoir d'appliquer le signal de verrouillage et mettre l'entrée LOCK à '1' afin de s'assurer que, après qu'il soit à nouveau alimenté, le module logique 110 redémarre bien à l'état par défaut sans être affecté par un effet de rémanence de la dernière donnée mémorisée.

Cette mise à un état logique '1' de l'entrée LOCK, peut correspondre à une activation ou une mise à un état logique '1' du signal « Tamper_Flag » consécutive à une détection de chute de tension d'alimentation. Une telle détection est mise en oeuvre par exemple un module ou circuit externe de détection d'accès frauduleux.

La figure 4 sert à illustrer un exemple de réalisation détaillé du module 110 logique évoqué précédemment et recevant les signaux de masquage dur issus des entrées de masquage dur HM1, HM2, respectivement sur une première entrée de contrôle LOCK et une deuxième entrée de contrôle HANDLE. Le module logique 110 intègre ici une bascule asynchrone 115, en particulier une bascule RS, dont l'entrée R est couplée à la première entrée de contrôle LOCK. La sortie d'une porte logique 113 réalisant une fonction logique entre la première entrée de contrôle LOCK et la deuxième entrée de contrôle HANDLE est appliquée à l'entrée S de la bascule. Par exemple, la porte logique 113 réalise une fonction NON OU entre la première entrée de contrôle LOCK et le complémentaire de la deuxième entrée de contrôle HANDLE. La sortie Q de la bascule 115 est couplée à une porte logique 117 réalisant par exemple une fonction NON OU et délivrant le signal OUT de sortie du module 110.

La bascule asynchrone 115 a pour particularité d'être asymétrique, de sorte, que lorsqu'elle est mise sous tension (représentée de manière schématique sur la figure 4 par un passage de la masse à un potentiel VDD de son alimentation) elle s'initialise toujours à un même état logique, ici par exemple un état logique '1' sur la sortie Q.

La bascule asynchrone 115 de type RS peut être rendue asymétrique, en en dimensionnant de manière asymétrique les deux portes NOR ou NAND qui composent cette bascule 115. Ainsi, par conception, on détermine la valeur d'initialisation du module 110 lorsque celui-ci est alimenté.

Un exemple de réalisation particulier d'une bascule RS asymétrique 115 est donné sur la figure 5.

La bascule 115 est formée d'un premier ensemble de transistors M1, M2, M5, M6 réalisant ici une fonction logique NON OU et d'un deuxième ensemble de transistors M3, M4, M7, M8 réalisant la même fonction logique que le premier ensemble de transistors M1, M2, M5, M6.

Le premier ensemble de transistors comporte un premier groupe de transistors M1, M2, dans cet exemple des transistors de type N, ayant un agencement semblable à celui d'un deuxième groupe de transistors M3, M4, de type N mais prévu avec une tension de seuil plus faible que celle des transistors M3, M4 du deuxième groupe.

Pour accentuer l'asymétrie, le premier ensemble de transistors peut être prévu avec un groupe de transistors M5, M6, dans cet exemple des transistors de type P, ayant un agencement semblable à celui d'un autre groupe de transistors M7, M8, de type P mais prévu avec une tension de seuil plus importante que celle des transistors M7, M8. En variante, ou en combinaison, l'asymétrie peut être également obtenue avec des géométries différentes des transistors les uns par rapport aux autres et en particulier de leur rapport (W/L) de largeur W sur longueur L du canal.

Avantageusement, on peut prévoir de doter une même mémoire SRAM de plusieurs unités de commande d'initialisation du type de celle décrite précédemment en lien avec la figure 1 chacune associée à un groupe de cellules particulier parmi un ensemble de cellules SRAM d'une matrice mémoire.

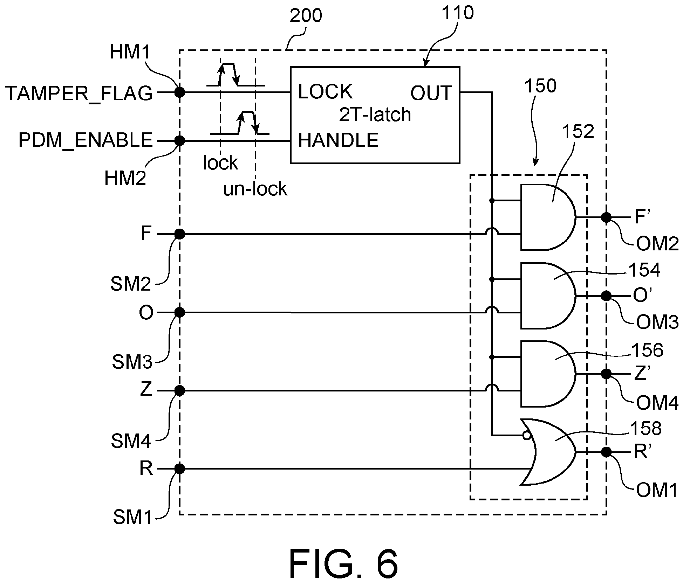

Ainsi, sur la figure 6, une autre unité 200 de commande d'initialisation pour commander l'initialisation d'au moins un autre groupe donné de cellules SRAM de la même mémoire SRAM que celle pourvue du groupe de cellules commandé par l'unité 100 de commande d'initialisation est illustré.

Cette autre unité 200 de commande d'initialisation a une structure similaire à celle de l'unité de commande 100 mais diffère notamment de celle décrite en lien avec la figure 1, en ce que son type d'initialisation par défaut correspond cette fois à une initialisation de type « aléatoire ». Le signal R' de commande d'initialisation aléatoire correspond donc, dans cet exemple, au signal de commande d'initialisation par défaut. Ce signal R' est émis sur la sortie OM1.

Les signaux indicateurs O, F, R, Z d'initialisation sont cette fois émis respectivement sur les entrées SM3, SM2, SM1, SM4, tandis que les signaux O', F', R', Z' de commande d'initialisation proviennent cette fois respectivement des sorties OM3, OM2, OM1, OM4.

Selon une possibilité de mise en oeuvre, l'unité de commande 100 et l'autre unité de commande 200 peuvent être dédiées à la gestion d'initialisation de groupes de cellules appartenant à différentes zones d'une matrice ou d'un plan mémoire.

Cela peut ainsi permettre de gérer différemment d'une zone à l'autre de la mémoire l'enchainement des initialisations et en outre de prévoir des types d'initialisation par défaut d'une zone à l'autre de la mémoire.

Un exemple de plan mémoire est représenté de manière schématique sur la figure 7 et comprend une matrice M de cellules mémoire. La matrice est formée typiquement d'une pluralité de lignes et de colonnes de cellules SRAM (non représentées sur cette figure). On distingue ici deux zones Z1, Z2 dans la matrice M, formées chacune d'un groupe de cellules. La mémoire comporte en particulier un premier groupe G1 de cellules situé dans une première zone Z1 de la matrice. Selon un mode de réalisation particulier, la première zone Z1 contient des cellules destinées à réaliser une fonction physique non-clonable (PUF) et dont l'état logique, en particulier l'état logique d'initialisation, est susceptible de servir pour former une signature numérique ou une empreinte numérique de la mémoire.

La mémoire comporte également un deuxième groupe G2 situé dans une deuxième zone Z2 de la matrice typiquement plus importante en termes de taille que la première zone Z1. Le deuxième groupe G2 peut être formé de plusieurs sous-groupes G21, G22 et avantageusement comporter un sous-groupe G22 de cellules pouvant stocker des données sensibles CSP (pour « Critical Security Parameters » ou paramètre de sécurité critique).

La mémoire peut alors disposer d'une unité de commande 100 d'initialisation telle que décrite par exemple en lien avec la figure 1 dédiée à la première zone Z1 correspondant à la fonction physique non-clonable (PUF). Une autre unité de commande 200 telle que décrite par exemple en lien avec la figure 6 peut être quant à elle dédiée à la deuxième zone Z2 et prévue pour contrôler l'initialisation du sous-groupe G22 de cellules CSP pouvant stocker des données sensibles. On peut gérer ainsi l'initialisation par défaut et le séquençage des initialisation de la zone Z1 dédiée au PUF différemment de ceux d'autres zones et en particulier de la zone de cellules CSP.

Les unités de commande 100, 200 d'initialisation peuvent être implémentés dans une région périphérique aux cellules mémoires par exemple une région dans laquelle un contrôleur de lignes ou de colonnes de la matrice est situé.

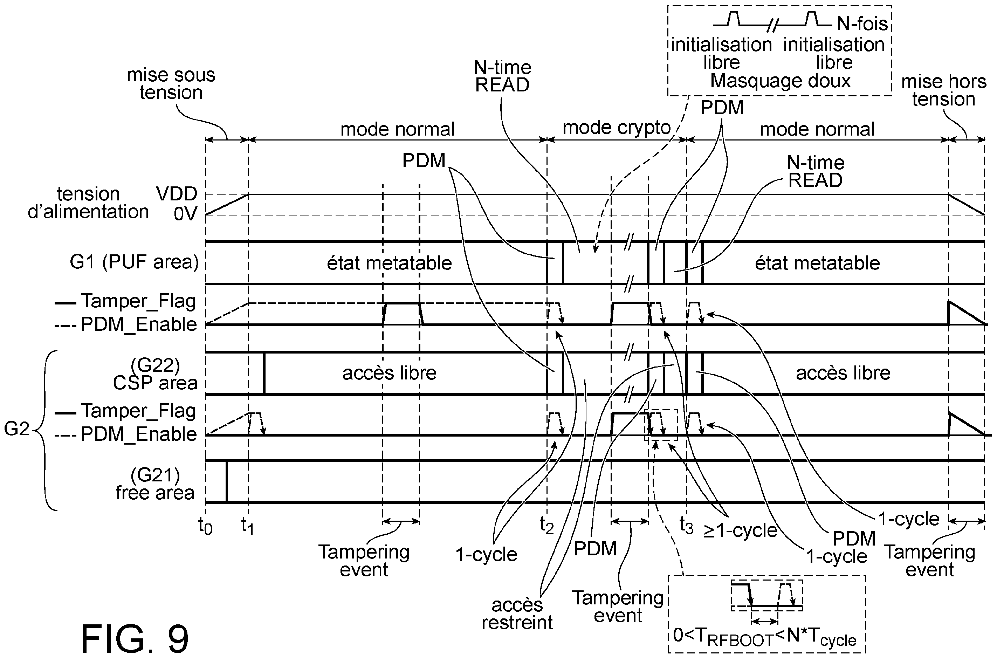

La figure 9 donne un exemple de chronogramme de fonctionnement d'un dispositif mémoire qui peut être doté d'une ou plusieurs unités de commande d'initialisation telles que décrites précédemment. L'échelle de temps sur ce chronogramme n'est pas représentée de manière linéaire, le rapport des durées respectivement entre les instants t1 et t2 et entre les instants t2 et 3 étant typiquement beaucoup plus important que sur cette représentation schématique.

La mise sous tension de la matrice mémoire se traduit ici par un passage de 0 à VDD d'une grille ou ligne conductrice entre un instant t0 et un instant t1. Les cellules du premier groupe G1 sont alors effacées puis maintenues dans un état métastable tandis que les cellules du sous-groupe G22 sont initialisées. Les cellules du sous-groupe G22 vont s'initialiser selon le type d'initialisation par défaut prévu pour la mise sous tension. Ainsi, on peut par exemple prévoir que les cellules de l'ensemble G22 auront une initialisation aléatoire. Pour mettre les cellules du premiergroupe G1 dans un état métastable, leur ligne d'alimentation haute VDD (figure 8) est déconnectée d'une grille ou ligne conductrice d'alimentation et/ou leurs noeuds internes N_{T} et N_{F} sont connectés l'un à l'autre, par exemple en activant leurs transistors d'accès TA_{T} et TA_{F} et en connectant entre elles les lignes de bits BLTi, ..., BLFi.

Un front descendant sur le signal d'activation PDM_ENABLE permet de mettre l'unité de commande associée au sous-groupe G22 de la zone CSP dans un état déverrouillé, tandis que l'unité de commande associée au premier groupe G1 reste dans un état verrouillé.

Durant une phase entre un instant t1 et un instant t2, le dispositif se trouve dans un mode de fonctionnement dit « normal », qui correspond à une majorité du temps global de fonctionnement de la matrice lorsqu'elle est alimentée, par exemple d'au moins 99% et dans cet exemple 99.9% du temps où la grille conductrice d'alimentation est alimentée et mise ainsi à la tension d'alimentation VDD.

Lorsque le signal de détection Tamper_flag est modifié par exemple suite à la détection d'une tentative d'intrusion ou d'accès frauduleux (« tampering event »), la ou les sorties de l'unité de commande associée au premier groupe G1 n'est ou ne sont pas modifiées.

Dans la zone CSP, on peut prévoir de ne pas modifier le signal de détection Tamper_flag dans le mode NORMAL. En effet, dans ce mode NORMAL, les données stockées par cette zone ne sont pas comme sensibles et ne nécessitent pas particulièrement d'être effacées.

Puis, à partir instant t2, un autre mode dit « crypto » est déclenché. Ce mode de fonctionnement peut être en particulier un mode de fonctionnement dans lequel on souhaite accéder aux cellules du premier groupe G1 afin de réaliser une procédure d'enrôlement pour déterminer les cellules que l'on souhaite utiliser pour créer une signature numérique et/ou une clef de cryptage (PUF), ou afin de lire une signature numérique et/ou une clef d'encryptage contenue dans certaines cellules du premier groupe G1. A un instant t2, l'état du signal d'activation PDM_ENABLE est tel qu'il ne modifie pas celui de la ou des sorties de l'unité de commande associée au premier groupe G1 de cellules. Puis, un front descendant sur le signal d'activation PDM_ENABLE permet de déverrouiller l'unité de commande associée au premier groupe G1 de cellules. Durant une phase « N-time READ » des initialisations selon des types d'initialisation qui peuvent être distincts du type d'initialisation par défaut peuvent être lancées. Par exemple, on peut effectuer des initialisations de type « libre » durant cette phase sur les cellules du premier groupe G1. Pendant ce temps la zone CSP se trouve dans un mode d'accès restreint.

Cela est possible en particulier lorsque chacune des zones PUF et CSP utilise sa propre unité de commande, l'unité de commande de la zone PUF pouvant être distincte de l'unité de commande de la zone CSP.

Durant le mode crypto, une tentative d'accès frauduleux (« tampering event ») à la mémoire peut être éventuellement détectée et se traduit par un changement d'état du signal de détection Tamper_flag qui, par le biais par exemple d'un passage à un état donné, ici un état haut correspondant à un '1' logique, permet de lancer une initialisation par défaut des cellules du premier groupe G1 et des cellules du sous-groupe G22. La ou les unités de commande associée(s) au premier groupe G1 et au sous-groupe G22 de cellules sont alors mises dans un état verrouillé. Les cellules du premier groupe G1 et des cellules du sous-groupe G22 sont alors mises dans un état métastable.

Une séquence de déverrouillage (changement d'état du signal de détection puis du signal d'activation) permet alors de remettre l'unité de commande associée au premier groupe G1 dans un état déverrouillé, ce qui permet à nouveau de réaliser une ou plusieurs initialisations sur les cellules du premier groupe G1 selon des types respectifs qui peuvent être distincts de celui de l'initialisation par défaut.

Un nouveau changement d'état du signal d'activation peut à partir d'un instant t3 permettre de revenir dans un mode de fonctionnement « normal ». Ce changement d'état peut intervenir notamment à la fin d'une opération d'enrôlement ou à la fin d'une opération « d'interrogation » ou de « challenge » de la zone PUF dans laquelle les cellules du premier groupe G1 peuvent être situées.

En variante d'un mode de réalisation décrit précédemment en liaison avec la figure 1, on peut prévoir que le verrouillage d'une zone mémoire déclenché par une séquence particulière de signaux n'est pas réalisé consécutivement à une détection d'accès frauduleux mais effectué de manière préventive. Ainsi, par exemple au lieu d'être généré par le module 11 de détection d'intrusion, le premier signal logique TAMPER_FLAG dit « de détection » décrit précédemment et émis en entrée de l'unité 100 de commande d'initialisation peut provenir d'un autre module que le module 11 de détection d'accès frauduleux évoqué précédemment. Par exemple, un microprocesseur ou un microcontrôleur, ou un circuit logique, externe au circuit mémoire transmet à l'unité 100 de commande d'initialisation le premier signal logique TAMPER_FLAG en prévention par exemple pour protéger une zone mémoire ou réserver un accès privilégié d'une zone mémoire. L'émission d'un tel signal de protection peut éventuellement être effectué avant même utilisation de la mémoire, par exemple après sa fabrication et lors d'un test en usine conduit par un opérateur. Cet opérateur ayant des droits d'administration sur la mémoire, déclenche l'émission du signal logique TAMPER_FLAG par le module externe précité, afin de générer une séquence permettant par exemple de verrouiller une zone mémoire particulière par exemple de type ROM et/ou contenant un code secret.

## Revendications

1. Unité de commande (100, 200) d'une mémoire SRAM pour déclencher une initialisation, sélectionnée parmi différents types d'initialisation distincts possibles, d'au moins un groupe donné de cellules mémoires SRAM de ladite mémoire SRAM, ladite unité de commande comprenant :
- une première entrée (HM1) dite « de masquage dur », apte à recevoir un signal dit « de détection » (TAMPER_FLAG),
- une deuxième entrée (HM2) dite « de masquage dur », apte à recevoir un signal dit « d'activation » (PDM_ENABLE),
- une ou plusieurs entrées (SM1, SM2, SM3, SM4) dites « de masquage doux » aptes à recevoir des signaux indicateurs d'initialisation selon différents types d'initialisation distincts,
ladite unité de commande étant configurée pour adopter un mode de fonctionnement dit « verrouillé », dans lequel consécutivement à une mise sous tension de la mémoire et quelle que soit la valeur de signaux émis sur la première entrée (HM1) et la deuxième entrée (HM2) de masquage dur et sur les entrées (SM1, SM2, SM3, SM4) de masquage doux, ou consécutivement à la réception d'une séquence dite « de verrouillage sur ladite première entrée (HM1) de masquage dur,
ladite unité de commande produise en sortie (OM1) un signal de commande (Z', R') dit « de masquage dur » apte à déclencher une initialisation dudit groupe donné de cellules selon un type d'initialisation dit « par défaut » correspondant à un premier type d'initialisation parmi lesdits différents types d'initialisation distincts ou un effacement, et maintient en sortie (OM1) ledit signal de commande (Z', R') « de masquage dur» dans un même état donné tant qu'une séquence de signaux particulière dite « de déverrouillage » n'est pas reçue sur lesdites entrées (HM1, HM2) de masquage dur,
ladite unité de commande étant configurée en outre pour, consécutivement à la réception de ladite séquence de signaux particulière dite « de déverrouillage » sur lesdites entrées (HM1, HM2) de masquage dur, adopter au moins un autre mode de fonctionnement dans lequel, en l'absence de nouveaux signaux ou de changement d'état de signaux sur lesdites entrées (HM1, HM2) de masquage dur, lorsque ladite unité de commande reçoit un signal indicateur (F, R, O, Z) d'initialisation du premier type d'initialisation, produire en sortie un signal de commande (Z', R') d'initialisation du premier type pour déclencher une initialisation des cellules mémoires dudit groupe donné de cellules selon ledit premier type d'initialisation et lorsque l'unité de commande reçoit un signal indicateur d'initialisation du deuxième type d'initialisation (F, O), produire en sortie un signal de commande d'initialisation (F', O')d'un deuxième type pour déclencher une initialisation des cellules mémoires dudit groupe donné de cellules selon ledit deuxième type d'initialisation.

2. Unité de commande selon la revendication 1, dans laquelle ledit signal de détection (TAMPER_FLAG) provient d'un module (11) de détection d'accès frauduleux à ladite mémoire SRAM, ladite séquence de verrouillage sur ladite première entrée (HM1) de masquage dur correspondant à un changement d'état dudit signal de détection (TAMPER_FLAG).

3. Unité de commande selon l'une des revendications 1 ou 2, dans laquelle ladite séquence de déverrouillage consiste, dans cet ordre, en un état logique donné ou un changement d'état logique dudit signal de détection (TAMPER_FLAG) sur ladite première entrée (HM2) de masquage dur vers ledit état logique donné puis, un changement du signal d'activation (PDM_ENABLE) sur ladite deuxième entrée (HM2) de masquage dur.

4. Unité de commande selon l'une des revendications 1 à 3, configurée en outre pour, dans ledit au moins un autre mode de fonctionnement, consécutivement à la réception dudit signal d'activation (PDM_ENABLE) sur la deuxième entrée (HM2) « de masquage dur » et en l'absence de changement d'état du signal de détection sur la première entrée (HM1) « de masquage dur », émettre un signal de commande de masquage dur pour déclencher une initialisation des cellules mémoires dudit groupe donné selon ledit type d'initialisation par défaut.

5. Unité de commande selon l'une des revendications 1 à 4, dans lequel l'unité de commande (100, 200) est dotée : d'un module logique (110) à bascule asynchrone ayant une entrée (LOCK) dite « de contrôle » couplée à la première entrée de masquage dur (HM1) et une autre entrée (HANDLE) dite « de contrôle » couplée à la deuxième entrée (HM2) de masquage dur, ledit module logique (110) étant configuré pour, consécutivement à une mise sous tension ou à la réception de ladite séquence de verrouillage, maintenir en sortie un premier état logique tant que ledit module logique (110) ne reçoit pas ladite séquence de déverrouillage et pour, consécutivement à la réception de ladite séquence de déverrouillage produire en sortie un deuxième état logique complémentaire dudit premier état logique.

6. Unité de commande selon la revendication 5, comprenant en outre un étage (150) à portes logiques couplé à une sortie (OUT) dudit module logique (110) et auxdites entrées de masquage doux, ledit étage (150) à portes logiques étant doté :
- d'au moins une première porte logique (158) réalisant une fonction logique donnée, en particulier réalisant une fonction OU entre une première entrée de masquage doux (SM4) et le complémentaire d'une sortie (OUT) dudit module logique (110), une sortie de la première porte logique (158) étant couplée à une première sortie (OM4) de l'unité de commande (100, 200) prévue pour délivrer le signal de commande d'initialisation du premier type,
- d'au moins une deuxième porte logique (152, 154, 156) réalisant une fonction logique distincte de la fonction logique donnée, en particulier une fonction ET entre une deuxième entrée (SM1, SM2, SM3) de ladite pluralité d'entrées « de masquage doux » et la sortie (OUT) dudit module logique (110) étant couplée à une deuxième sortie (OM1, OM2, OM3) de l'unité de commande (100, 200) prévue pour délivrer le signal de commande d'initialisation du deuxième type.

7. Unité de commande selon l'une des revendications 6 ou 5, dans lequel le module logique (110) à bascule asynchrone (115) est doté d'une bascule asynchrone asymétrique tel qu'une bascule RS asymétrique.

8. Unité de commande selon la revendication 7, dans laquelle ladite bascule asynchrone (115) est formée d'un premier ensemble de transistors (M1, M2, M5, M6) réalisant une fonction logique donnée, en particulier une fonction NON OU ou une fonction NON ET, et d'un deuxième ensemble de transistors (M3, M4, M7, M8) réalisant ladite même fonction logique donnée, ladite bascule asynchrone (115) étant asymétrique de sorte que ledit premier ensemble de transistors (M1, M2, M5, M6) est doté d'au moins un premier groupe de transistors (M1, M2) ayant un agencement semblable à celui d'un deuxième groupe de transistors (M3, M4) dudit deuxième ensemble de transistors, les transistors (M1, M2) du premier groupe étant prévus avec une tension de seuil ou une taille différente de celle des transistors (M3, M4) dudit deuxième groupe.

9. Unité de commande selon l'une des revendications 1 à 8, dans laquelle parmi lesdites entrées de masquage doux :
- une première entrée (SM1) « de masquage doux » est apte à recevoir un signal (Z) indicateur d'initialisation d'un premier type d'initialisation,
- une deuxième entrée (SM2) de masquage doux, apte à recevoir un signal indicateur (F) d'initialisation d'un deuxième type d'initialisation parmi lesdites différents types d'initialisation, le deuxième type d'initialisation étant distinct dudit premier type d'initialisation et dudit deuxième type d'initialisation,
- une troisième entrée (SM3) de masquage doux, apte à recevoir un signal indicateur d'initialisation (F, R, Z) d'un troisième type d'initialisation parmi lesdites différents types d'initialisation, le troisième type d'initialisation étant distinct dudit premier type d'initialisation et dudit deuxième type d'initialisation,
dans laquelle dans ledit au moins un autre mode de fonctionnement lorsque la troisième entrée de masquage doux reçoit un signal indicateur d'initialisation du troisième type d'initialisation, l'unité de commande produit en sortie un signal de commande d'initialisation d'un troisième type pour déclencher une initialisation des cellules mémoires dudit groupe donné de cellules selon ledit troisième type d'initialisation.

10. Unité de commande selon l'une des revendications 1 à 9, le premier type d'initialisation et le deuxième type d'initialisation sont des types d'initialisation distincts parmi :
- une initialisation de type «mise à 1 » ou « mise à 0 » consistant à mettre toutes les cellules dudit groupe à un même état logique,
- une initialisation de type « aléatoire » consistant à imposer à chaque colonne de cellules dudit groupe un même état logique donné sélectionné de manière aléatoire entre un premier état logique et un deuxième état logique,
- une initialisation de type « libre » consistant à mettre les noeuds internes de chaque cellule dudit groupe à un même potentiel puis laisser ces noeuds internes respectivement se charger ou se décharger afin de laisser la cellule s'établir librement à un état logique donné.

11. Unité de commande selon l'une des revendications 1 à 10, dans laquelle, dans le mode de fonctionnement verrouillé, ledit maintient en sortie (OM1) dudit signal de commande (Z') de masquage dur dans un même état donné est apte à maintenir ledit groupe donné de cellules dans un état indéterminé dit « métastable » pour lequel leur premier noeud (N_{T}) de stockage et leur deuxième noeud (N_{F}) de stockage respectifs sont mis à des potentiels égaux ou sensiblement égaux.

12. Dispositif de mémoire statique à accès aléatoire comprenant :
- un ensemble de cellules SRAM comprenant ledit groupe donné de cellules SRAM,
- au moins une première unité de commande (100) suivant l'une des revendications 1 à 11, pour initialiser ledit groupe donné dudit ensemble de cellules SRAM.

13. Dispositif de mémoire statique à accès aléatoire selon la revendication 12, comprenant en outre:
- une deuxième unité (200) de commande selon la revendication 1, pour commander l'initialisation, selon différents types d'initialisation distincts possibles, des cellules mémoires d'un deuxième groupe de cellules dudit ensemble de cellules mémoires SRAM distinct dudit groupe donné.

14. Dispositif de mémoire statique à accès aléatoire selon l'une des revendications 12 ou 13, dans lequel ledit groupe donné de cellules contient une fonction physique non clonable (PUF), ledit deuxième groupe de cellules correspondant à des cellules de stockage de données sensible ou à des cellules en accès libre.

15. Dispositif de mémoire statique à accès aléatoire selon l'une des revendications 12 à 14, dans lequel la deuxième unité de commande (200) est configurée pour, consécutivement à chaque mise sous tension de la mémoire ou consécutivement à la réception d'un signal de verrouillage (TAMPER_FLAG), produire en sortie un signal de commande d'initialisation pour déclencher une initialisation dudit deuxième groupe de cellules selon un type d'initialisation par défaut parmi lesdits différents types d'initialisation distincts, le type d'initialisation par défaut de la deuxième unité de commande étant différent du type d'initialisation par défaut de la première unité de commande et sélectionné parmi :
- une initialisation de type « mise à 1 » ou « mise à 0 » consistant à mettre toutes les cellules dudit groupe à un même état logique,
- une initialisation de type « déterministe aléatoire » consistant à imposer à chaque colonne de cellules dudit groupe un même état logique donné sélectionné de par tirage aléatoire entre un premier état logique et un deuxième état logique,
- une initialisation de type « libre » consistant à mettre les noeuds internes de chaque cellule dudit groupe à un même potentiel puis laisser ces noeuds internes respectivement se charger ou se décharger afin de laisser la cellule s'établir librement à un état logique donné.

16. Dispositif de mémoire statique à accès aléatoire selon la revendication 15, le type d'initialisation par défaut de la première unité de commande étant une initialisation de type «mise à 1 » ou « mise à 0 » consistant à mettre toutes les cellules dudit groupe à un même état logique, le type d'initialisation par défaut de la deuxième unité de commande étant une initialisation de type « déterministe aléatoire » consistant à imposer à chaque colonne de cellules dudit groupe un même état logique donné sélectionné de manière aléatoire entre un premier état logique et un deuxième état logique.
